# EUROPEAN PATENT SPECIFICATION

(11) **EP 4 525 574 B1**
(45) Date of publication and mention of the grant of the patent: **10.12.2025**
(21) Application number: 24195607.7
(22) Date of filing: 21.08.2024
(51) Int. Cl.: H05K 7/14, H05K 7/20

(54) **CONNECTING ASSEMBLY AND ELECTRONIC APPARATUS THEREWITH**
VERBINDUNGSANORDNUNG UND ELEKTRONISCHES GERÄT DAMIT
ENSEMBLE DE CONNEXION ET APPAREIL ÉLECTRONIQUE LE COMPRENANT

(30) Priority: 08.09.2023 US 202363537201 P; 15.03.2024 TW 113109745
(43) Date of publication of application: 19.03.2025
(73) Proprietor: Moxa Inc., New Taipei City 242 (TW)
(72) Inventor: Huang, Yi-Chun, 242 New Taipei City (TW); Wei, Ru-Fan, 242 New Taipei City (TW)
(74) Representative: Straus, Alexander

(56) References cited:
- US-A1- 2005 215 107
- US-A1- 2021 100 123

## Description

### Field of the Invention

The present invention relates to a connecting assembly and an electronic apparatus according to the pre-characterizing clauses of claims 1 and 11.

### Background of the Invention

In order to satisfy different demands in different fields, modularity has gradually become a mainstream trend of electronic apparatuses. The electronic apparatus usually includes multiple detachable devices structurally and electrically connected to each other. For example, the detachable device can be a power supply device, a signal switch device, or a computing device. Therefore, it is an important topic in the field to provide a tight and firm aligning connection between the two detachable devices for improving a reliability of the electronic apparatus. An example of an apparatus providing an alignment mechanism between 2 devices is disclosed by the document US2021/100123, DALLASERRA Luc, published on 1 April 2021.

### Summary of the Invention

This is mind, the present invention aims at providing a connecting assembly for providing an aligning connection between a first electronic device and a second electronic device tightly and firmly, and an electronic apparatus therewith.

This is achieved by a connecting assembly and an electronic apparatus according to claims 1 and 11. The dependent claims pertain to corresponding further developments and improvements.

As will be seen more clearly from the detail description following below, the claimed connecting assembly for aligning and connecting a first electronic device and a second electronic device includes a first connecting component, a plurality of first heat dissipating fins, a second connecting component, a plurality of second heat dissipating fins, and a pin protruding. The first connecting component is disposed on the first electronic device. The plurality of first heat dissipating fins are disposed on the first connecting component. An engaging portion is formed on at least one of the plurality of first heat dissipating fins. The second connecting component is disposed on the second electronic device. The plurality of second heat dissipating fins are disposed on the second connecting component. A cooperating engaging portion is formed on at least one of the plurality of second heat dissipating fins. The pin protrudes from the first connecting component and configured to be inserted into the second connecting component along a first direction. When the pin is inserted into the second connecting component along the first direction, the plurality of first heat dissipating fins are configured to respectively be aligned with and abut against the plurality of second heat dissipating fins along the first direction, and the engaging portion is configured to engage with the cooperating engaging portion along the first direction and abut against the cooperating engaging portion along a second direction and a third direction opposite to each other and perpendicular to the first direction.

Besides, the claimed electronic apparatus includes a first electronic device, a second electronic device detachably connected to the first electronic device, and the aforementioned connecting assembly for providing an aligning connection between the first electronic device and the second electronic device.

In summary, in the present invention, a cooperation of the engaging portion and the cooperating engaging portion can provide support for the pin along a vertical direction relative to the pin for reducing a vertical shear force acting on the pin, so as to prevent the pin from being damaged or broken. Besides, the cooperation of the engaging portion and the cooperating engaging portion also can ensure the first electronic device and the second electronic device to be connected to each other and prevent the first electronic device or the second electronic device from being connected to another electronic device by mistake, so as to achieve a foolproof effect. From the above, the present invention has improved reliability in use.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof:
FIG. 1 is a schematic diagram of an electronic apparatus according to an embodiment of the present invention,
FIG. 2 and FIG. 3 are exploded diagrams of the electronic apparatus at different views according to the embodiment of the present invention,
FIG. 4 to FIG. 7 are partial sectional diagrams of the electronic apparatus along different sectional lines according to the embodiment of the present invention,
FIG. 8 is a partial sectional exploded diagram of the electronic apparatus according to the embodiment of the present invention,
FIG. 9 is a partial structural diagram of the electronic apparatus in a non-locked state according to the embodiment of the present invention,
FIG. 10 and FIG. 11 are partial sectional diagrams of the electronic apparatus in the non-locked state along different sectional lines according to the embodiment of the present invention,
FIG. 12 is a partial structural diagram of the electronic apparatus in a locked state according to the embodiment of the present invention, and
FIG. 13 and FIG. 14 are partial sectional diagrams of the electronic apparatus in the locked state along different sectional lines according to the embodiment of the present invention.

### Detailed Description

In the following detailed description of the preferred embodiments, reference is made to the accompanying drawings which form a part hereof, and in which is shown by way of illustration specific embodiments in which the invention may be practiced. In this regard, directional terminology, such as "top", "bottom", "left", "right", "front", "back", etc., is used with reference to the orientation of the Figure(s) being described. The components of the present invention can be positioned in a number of different orientations. As such, the directional terminology is used for purposes of illustration and is in no way limiting. Accordingly, the drawings and descriptions will be regarded as illustrative in nature and not as restrictive. Also, if not specified, the term "connect" is intended to mean either an indirect or direct electrical/mechanical connection. Thus, if a first device is connected to a second device, that connection may be through a direct electrical/mechanical connection, or through an indirect electrical/mechanical connection via other devices and connections.

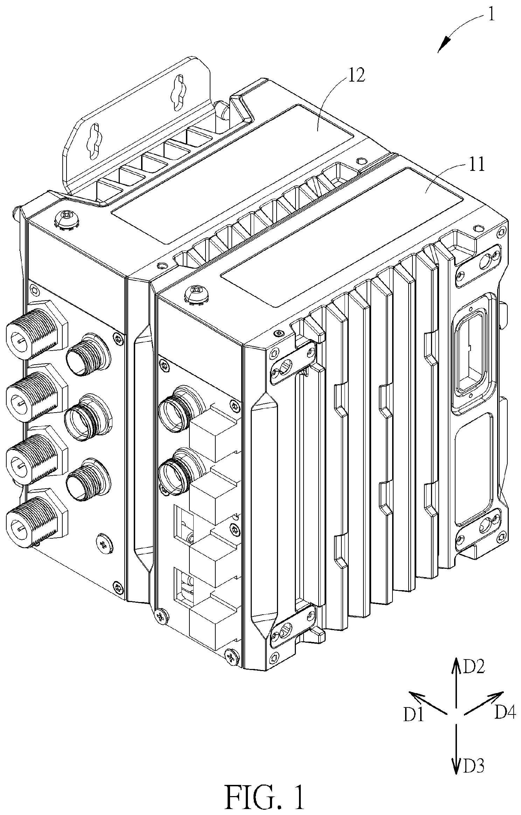

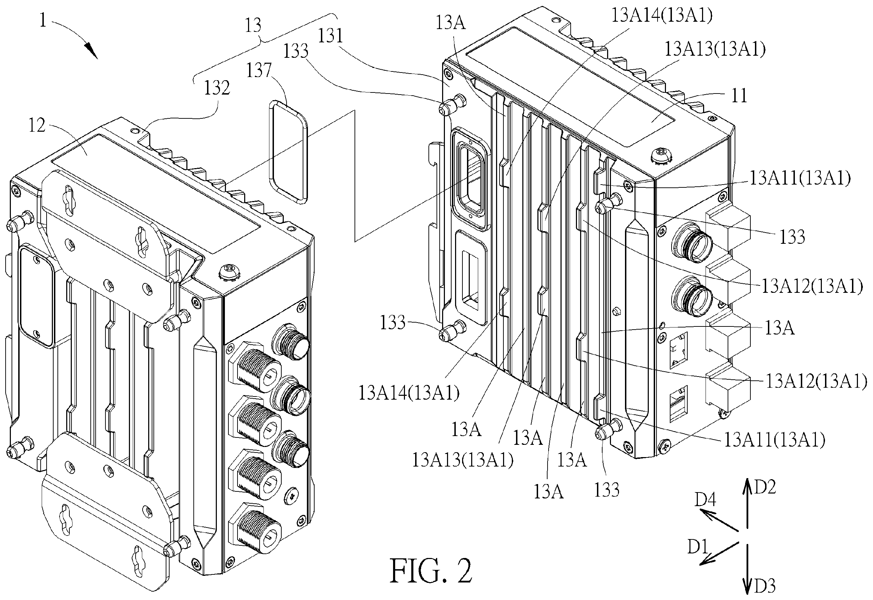

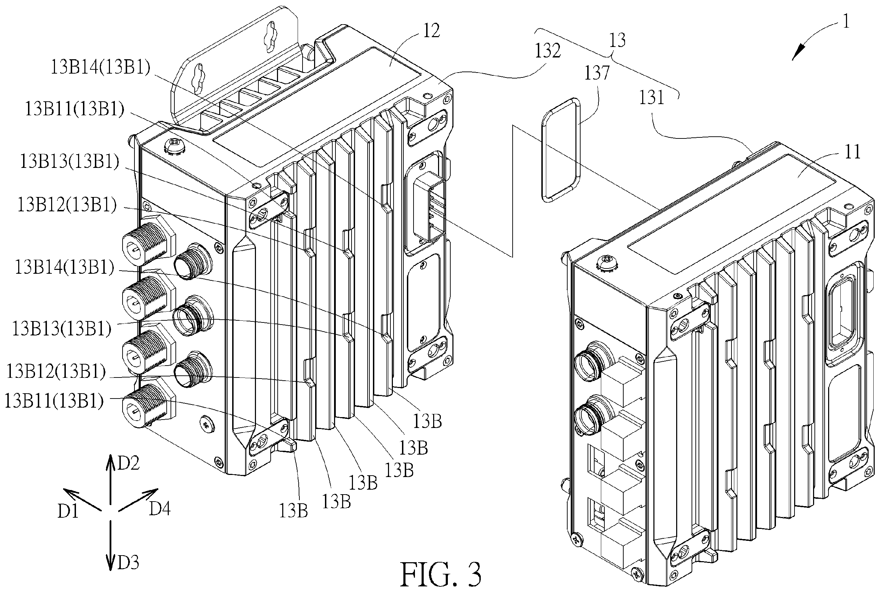

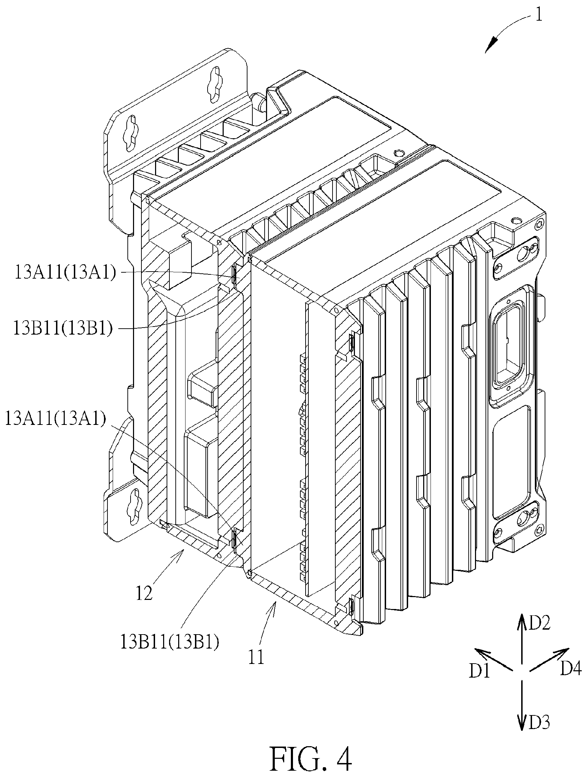

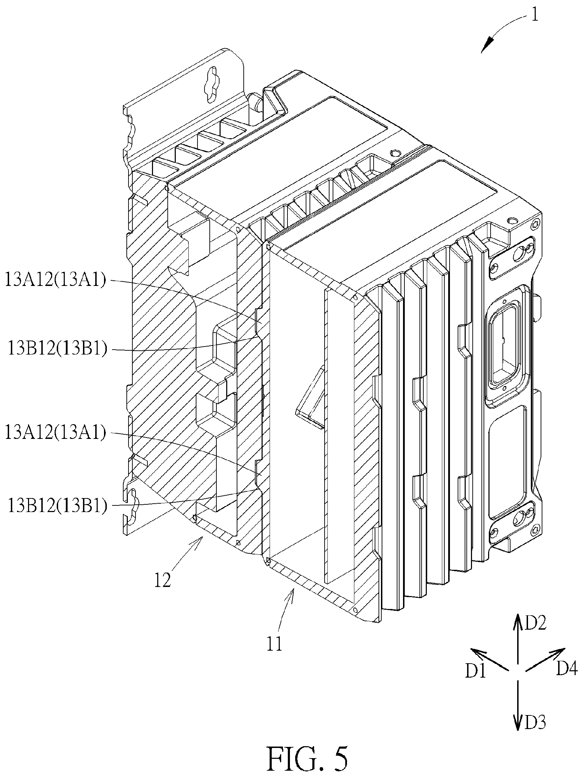

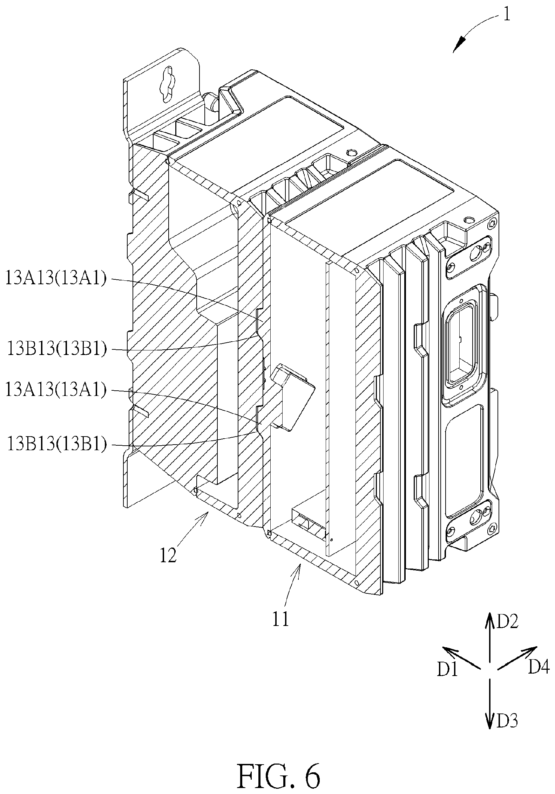

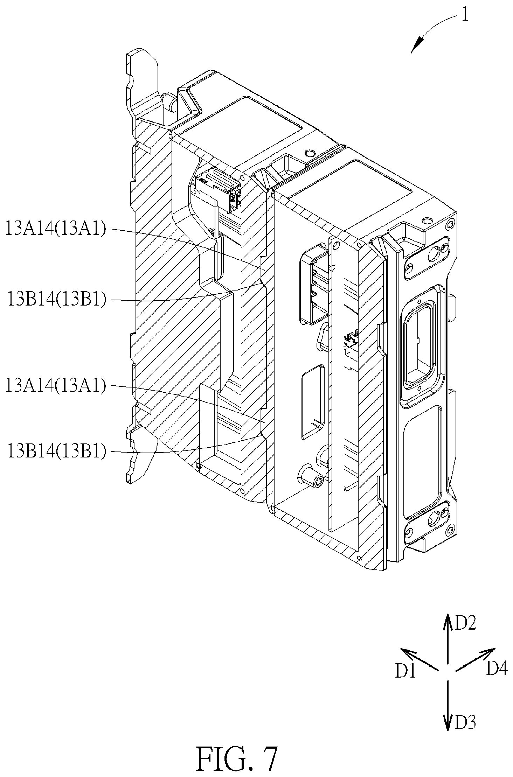

Please refer to FIG. 1 to FIG. 7. FIG. 1 is a schematic diagram of an electronic apparatus 1 according to an embodiment of the present invention. FIG. 2 and FIG. 3 are exploded diagrams of the electronic apparatus 1 at different views according to the embodiment of the present invention. FIG. 4 to FIG. 7 are partial sectional diagrams of the electronic apparatus 1 along different sectional lines according to the embodiment of the present invention. As shown in FIG. 1 to FIG. 7, the electronic apparatus 1 includes a first electronic device 11 and a second electronic device 12. The second electronic device 12 is detachably connected to the first electronic device 11. In this embodiment, the electronic apparatus 1 can be a remote terminal unit, and the first electronic device 11 and the second electronic device 12 can be a signal switch device and a radio frequency (RF) communication device, respectively. However, the present invention is not limited to this embodiment.

As shown in FIG. 2 to FIG. 7, the electronic apparatus 1 further includes a connecting assembly 13 configured to provide a tight and firm aligning connection between the first electronic device 11 and the second electronic device 12. The connecting assembly 13 includes a first connecting component 131, a second connecting component 132, four pins 133, six first heat dissipating fins 13A and six second heat dissipating fins 13B. The first connecting component 131 is disposed on the first electronic device 11. The second connecting component 132 is disposed on the second electronic device 12. Each of the pins 133 protrudes from the first connecting component 131 and is configured to be inserted into the second connecting component 132 along a first direction D1. Preferably, the four pins 133 are located on four corners of the first connecting component 131, respectively. The six first heat dissipating fins 13A are disposed on the first connecting component 131 and configured to dissipate heat generated by the first electronic device 11 rapidly. The six second heat dissipating fins 13B are disposed on the second connecting component 132 and configured to dissipate heat generated by the second electronic device 12 rapidly. Two engaging portions 13A1 are formed on each of four of the six first heat dissipating fins 13A. Two cooperating engaging portions 13B1 are formed on each of four of the six second heat dissipating fins 13B.

When each of the pins 133 is inserted into the second connecting component 132 along the first direction D1, the six first heat dissipating fins 13A are configured to be aligned with and abut against the six second heat dissipating fins 13B, respectively, and each of the engaging portions 13A1 is configured to engage with the corresponding cooperating engaging portion 13B1 along the first direction D1 and abut against the corresponding cooperating engaging portion 13B1 along a second direction D2 and a third direction D3 opposite to each other and perpendicular to the first direction D1. An abutting cooperation of each of the engaging portions 13A1 and the corresponding cooperating engaging portion 13B1 can provide support for the pin 133 along a vertical direction relative to the pin 133 for reducing a vertical shear force acting on the pin 133, so as to prevent the pin 133 from being damaged or broken. Besides, the abutting cooperation of each of the engaging portions 13A1 and the corresponding cooperating engaging portion 13B1 also can ensure the first electronic device 11 and the second electronic device 12 to be connected to each other and prevent the first electronic device 11 or the second electronic device 12 from being connected to another electronic device by mistake, so as to achieve a foolproof effect.

Understandably, the numbers of the pin, the first heat dissipating fin, the second heat dissipating fin, the engaging portion and the cooperating engaging portion are not limited to this embodiment. For example, in another embodiment, the connecting assembly can include one pin, two first heat dissipating fins and two second heat dissipating fins, and one engaging portion and one cooperating engaging portion are formed on one of the two first heat dissipating fins and one of the two second heat dissipating fins, respectively.

Furthermore, in this embodiment, as shown in FIG. 2 and FIG. 3, the first connecting component 131 can be integrally connected to a left cover of the first electronic device 11, and the second connecting component 132 can be integrally connected to a right cover of the second electronic device 12. However, the present invention is not limited to this embodiment. For example, in another embodiment, the first connecting component can be an independent member detachably connected to the left cover of the first electronic device, and the second connecting component can be an independent member detachably connected to the right cover of the second electronic device.

Besides, in this embodiment, as shown in FIG. 2 and FIG. 3, the first heat dissipating fins 13A can be integrally connected to the first connecting component 131, and the second heat dissipating fins 13B can be integrally connected to the second connecting component 132. However, the present invention is not limited to this embodiment. For example, in another embodiment, the first heat dissipating fins can be an independent member detachably connected to the first connecting component, and the second heat dissipating fins can be an independent member detachably connected to the second connecting component.

Preferably, in order to ensure smooth engagement of the engaging portion 13A1 and the cooperating engaging portion 13B1, as shown in FIG. 2 and FIG. 3, the engaging portion 13A1 and the cooperating engaging portion 13B1 can be an engaging protrusion and an engaging recess. A width of the engaging protrusion can gradually decrease from a bottom of the engaging protrusion, and a width of the engaging recess can gradually increase from a bottom of the engaging recess. For example, the engaging protrusion can be a trapezoid-shaped protrusion with a width gradually decreasing along the first direction D1, and the engaging recess can be a trapezoid-shaped recess with a width gradually decreasing along the first direction D1. Such configuration guides the engaging portion 13A1 and the cooperating engaging portion 13B1 to be aligned with each other by a sliding cooperation between corresponding inclined surfaces thereof during a process of that the first electronic device 11 and the second electronic device 12 move toward each other. However, the present invention is not limited to this embodiment. For example, in another embodiment, the engaging portion and the cooperating engaging portion can be an engaging recess and an engaging protrusion, and the engaging portion and the cooperating engaging portion have substantially uniform widths, i.e., the engaging portion and the cooperating engaging portion can be a rectangular recess and a rectangular protrusion, respectively.

In addition, in order to prevent stress concentration, as shown in FIG. 2, a first one, a second one, a third one, a fourth one, a fifth one and a sixth one of the six first heat dissipating fins 13A can be sequentially arranged along a fourth direction D4, and the engaging portions 13A1 on the first one, the second one, the fourth one and the sixth one of the six first heat dissipating fins 13A can be considered as two first engaging portions 13A11, two second engaging portions 13A12, two third engaging portions 13A13 and two fourth engaging portions 13A14, respectively. The second one of the six first heat dissipating fins 13A, whereon the second engaging portions 13A12 are formed, is located between the first one and the fourth one of the six first heat dissipating fins 13A, whereon the first engaging portions 13A11 and the third engaging portions 13A13 are respectively formed, along the fourth direction D4. Each of the second engaging portions 13A12 and the corresponding first engaging portion 13A11 are misaligned from each other along the fourth direction D4. Each of the second engaging portions 13A12 and the corresponding third engaging portion 13A13 are misaligned from each other along the fourth direction D4. The fourth one of the six first heat dissipating fins 13A, whereon the third engaging portions 13A13 are formed, is located between the second one and the sixth one of the six first heat dissipating fins 13A, whereon the second engaging portions 13A12 and the fourth engaging portions 13A14 are respectively formed, along the fourth direction D4. Each of the third engaging portions 13A13 and the corresponding second engaging portion 13A12 are misaligned from each other along the fourth direction D4. Each of the third engaging portions 13A13 and the corresponding fourth engaging portion 13A14 are misaligned from each other along the fourth direction D4.

Correspondingly, as shown in FIG. 3, a first one, a second one, a third one, a fourth one, a fifth one and a sixth one of the six second heat dissipating fins 13B can be sequentially arranged along the fourth direction D4, and the cooperating engaging portions 13B1 on the first one, the second one, the fourth one and the sixth one of the six second heat dissipating fins 13B can be considered as two first cooperating engaging portions 13B11, two second cooperating engaging portions 13B12, two third cooperating engaging portions 13B13 and two fourth cooperating engaging portions 13B14. The second one of the six second heat dissipating fins 13B, whereon the second cooperating engaging portions 13B12 are formed, is located between the first one and the fourth one of the six second heat dissipating fins 13B, whereon the first cooperating engaging portions 13B11 and the third cooperating engaging portions 13B13 are respectively formed, along the fourth direction D4. Each of the second cooperating engaging portions 13B12 and the corresponding first cooperating engaging portion 13B11 are misaligned from each other along the fourth direction D4. Each of the second cooperating engaging portions 13B12 and the corresponding third cooperating engaging portion 13B13 are misaligned from each other along the fourth direction D4. The fourth one of the six second heat dissipating fins 13B, whereon the third cooperating engaging portions 13B13 are formed, is located between the second one and the sixth one of the six second heat dissipating fins 13B, whereon the second cooperating engaging portions 13B12 and the fourth cooperating engaging portions 13B14 are respectively formed, along the fourth direction D4. Each of the third cooperating engaging portions 13B13 and the corresponding second cooperating engaging portion 13B12 are misaligned from each other along the fourth direction D4. Each of the third cooperating engaging portions 13B13 and the corresponding fourth cooperating engaging portion 13B14 are misaligned from each other along the fourth direction D4.

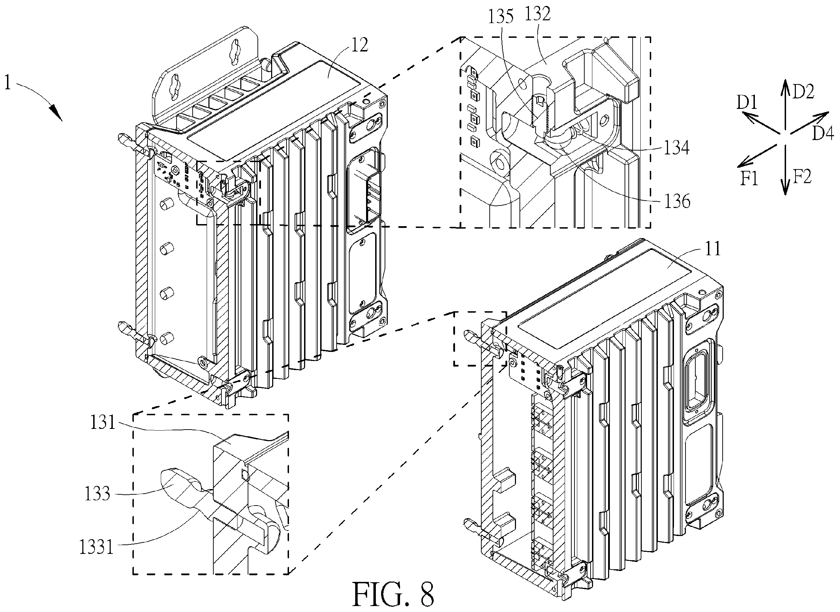

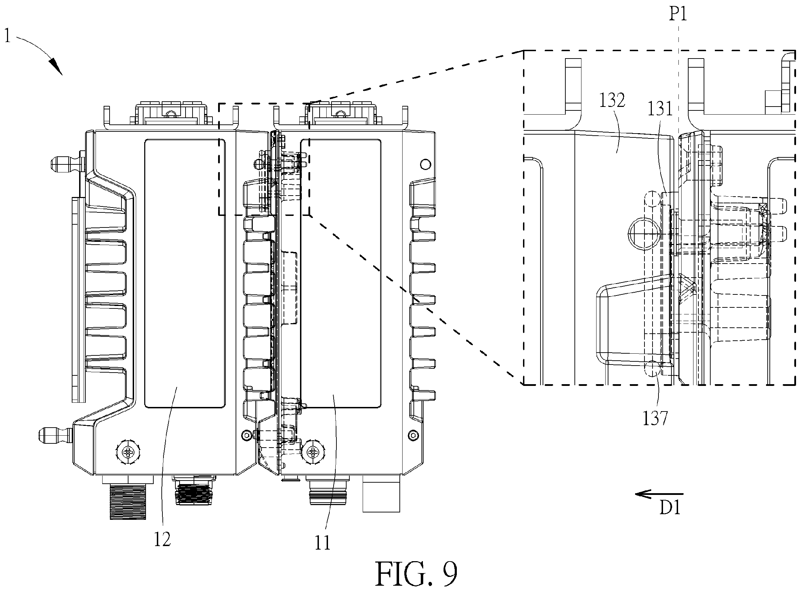

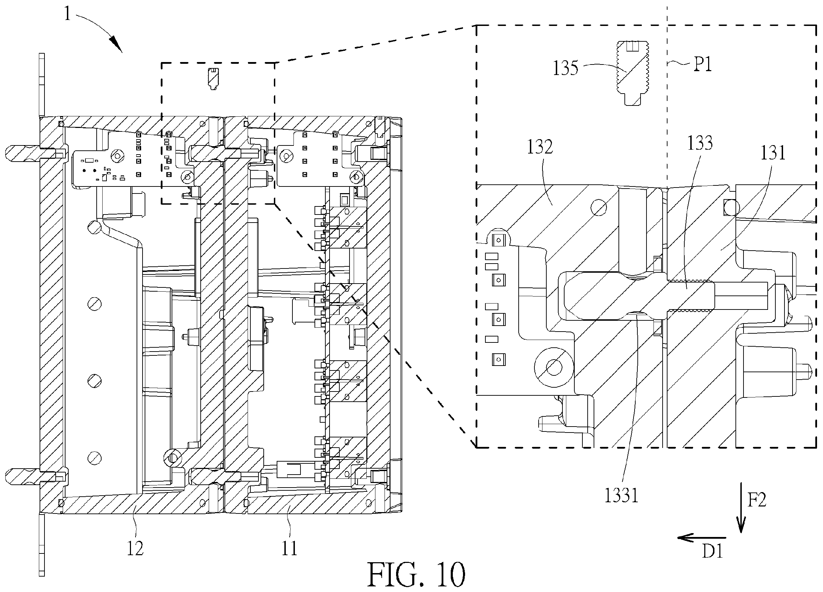

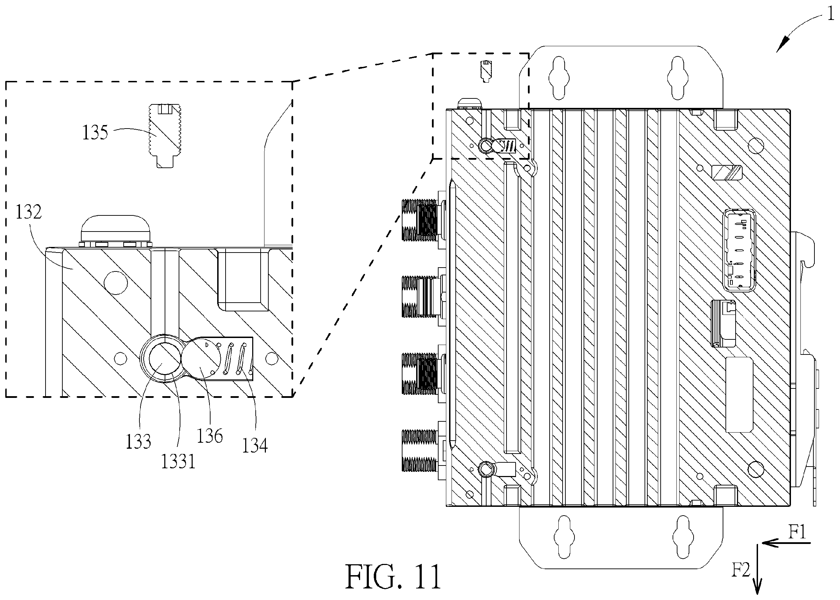

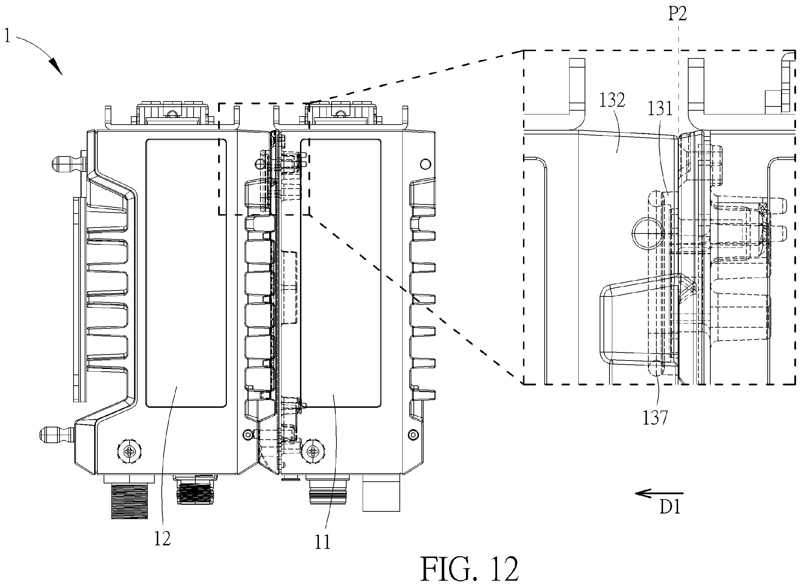

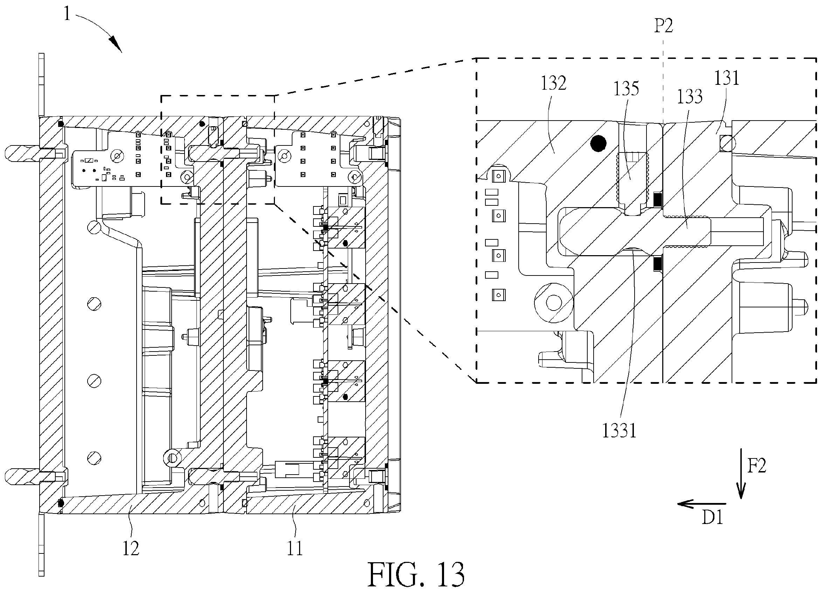

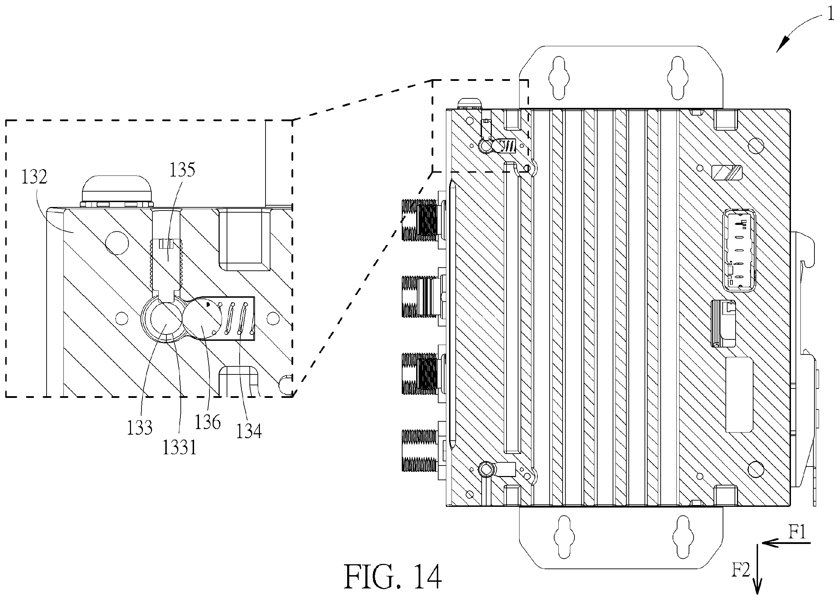

Please further refer to FIG. 2, FIG. 3 and FIG .8 to FIG. 14. FIG. 8 is a partial sectional exploded diagram of the electronic apparatus 1 according to the embodiment of the present invention. FIG. 9 is a partial structural diagram of the electronic apparatus 1 in a non-locked state according to the embodiment of the present invention. FIG. 10 and FIG. 11 are partial sectional diagrams of the electronic apparatus 1 in the non-locked state along different sectional lines according to the embodiment of the present invention. FIG. 12 is a partial structural diagram of the electronic apparatus 1 in a locked state according to the embodiment of the present invention. FIG. 13 and FIG. 14 are partial sectional diagrams of the electronic apparatus 1 in the locked state along different sectional lines according to the embodiment of the present invention. As shown in FIG. 2, FIG. 3 and FIG .8 to FIG. 14, in order to lock the four pins 133 inserted into the second connecting component 132, the connecting assembly 13 further includes four resilient components 134, four locking components 135 and four abutting components 136. Each of the resilient components 134 is disposed inside the second connecting component 132 and configured to apply a radial resilient force onto the corresponding pin 133 inserted into the second connecting component 132. Each of the locking components 135 is screwed onto the second connecting component 132 and configured to apply a radial locking force onto the corresponding pin 133 inserted into the second connecting component 132. Each of the abutting components 136 is disposed inside the second connecting component 132 and configured to abut against the corresponding pin 133. In other words, the resilient component 134 is configured to abut against the abutting component 136 to indirectly apply the radial resilient force onto the pin 133 via the abutting component 136. For example, as shown in FIG. 8, the resilient component 134 is configured to apply the radial resilient force onto the corresponding pin 133 inserted into the second connecting component 132 along a first forcing direction F1, and the locking components 135 is configured to apply the radial locking force onto the corresponding pin 133 inserted into the second connecting component 132 along a second forcing direction F2, wherein the first forcing direction F1 and the second forcing direction F2 can be substantially perpendicular to each other and substantially perpendicular to the first direction D1, and first forcing direction F1 and the second forcing direction F2 can be substantially opposite to the fourth direction D4 and the second direction D2, respectively.

In this embodiment, the locking component 135 can be a screw or a bolt, and the resilient component 134 can be a compression spring. Furthermore, in this embodiment, the abutting component 136 can be a ball-shaped structure made of metal material. However, the present invention is not limited to this embodiment. For example, in another embodiment, the abutting component can be a protruding platform made of plastic material or resilient material.

Understandably, the numbers of the pin, the resilient component and the locking component are not limited to this embodiment. For example, in another embodiment, the connecting assembly can include one pin, one resilient component and one locking component.

Understandably, the locking configuration for locking the pin is not limited to this embodiment. For example, in another embodiment, the abutting component can be omitted, and the resilient component can be a U-shaped spring configured to directly abut against two opposite sides of the pin to directly apply two radial resilient forces onto the pin along two opposite directions.

Specifically, as shown in FIG. 2, FIG. 3 and FIG. 8 to FIG. 14, a groove 1331 is formed on an outer periphery of each of the pins 133 along a circumferential direction of the corresponding pin 133 and configured to cooperate with the corresponding abutting component 136 and the corresponding locking component 135. Each of the grooves 1331 is abutted by the corresponding abutting component 136 along the first forcing direction F1 and the corresponding locking component 135 along the second forcing direction F2, so as to lock the corresponding pin 133 with the radial resilient force generated by the corresponding resilient component 134 along the first forcing direction F1 and the radial locking force generated by the corresponding locking component 135 along the second forcing direction F2 perpendicular to the first forcing direction F1.

Understandably, in another embodiment, there can be two different grooves formed on the pin and configured to be abutted by the abutting component and the locking component, respectively, and the resilient component and the locking component can be configured to apply the radial resilient force and the radial locking force onto the pin along two opposite directions, respectively.

Moreover, as shown in FIG. 2, FIG. 3 and FIG. 8 to FIG. 14, the connecting assembly 13 further includes a sealing component 137 disposed between the first connecting component 131 and the second connecting component 132. The sealing component 137 can be made of resilient material. The sealing component 137 can position the pin 133 at an initial inserting position as shown in FIG. 9 and FIG. 10 when the pin 133 is inserted to the second connecting component 132. Afterwards, when the locking component 135 is screwed onto the second connecting component 132, a cooperation of the locking component 135 and the groove 1331 can drive the pin 133 to move from the initial inserting position P1 as shown in FIG. 9 and FIG. 10 to a predetermined inserting position P2 as shown in FIG. 12 and FIG. 13 along the first direction D1, so as to drive the first connecting component 131 to move along the first direction D1 together with the pin 133, such that the sealing component 137 is clamped to be resiliently deformed by the first connecting component 131 and the second connecting component 132. The aforementioned configuration achieves seamless connection of the first connecting component 131 and the second connecting component 132 to meet requirements of dustproof and waterproof functions for preventing moisture or particle from entering into the first electronic device 11 and/or the second electronic device 12.

In this embodiment, the sealing component 137 can be an O-shaped sealing ring surrounding an electrical connector of the first electronic device 11 and an electrical connector of the second electronic device 12. However, the present invention is not limited to this embodiment.

Understandably, in another embodiment, if there is no demand for dustproof and waterproof functions, the sealing component can be omitted. Furthermore, the pin can be configured to be located at the predetermined inserting position when being inserted into the second connecting component, and the locking component can be configured to lock the pin located at the predetermined inserting position after insertion of the pin into the second connecting component.

In contrast to the prior art, in the present invention, a cooperation of the engaging portion and the cooperating engaging portion can provide support for the pin along a vertical direction relative to the pin for reducing a vertical shear force acting on the pin, so as to prevent the pin from being damaged or broken. Besides, the cooperation of the engaging portion and the cooperating engaging portion also can ensure the first electronic device and the second electronic device to be connected to each other and prevent the first electronic device or the second electronic device from being connected to another electronic device by mistake, so as to achieve a foolproof effect. From the above, the present invention has improved reliability in use.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A connecting assembly (13) for providing an aligning connection between a first electronic device (11) and a second electronic device (12), a first connecting component (131) disposed on the first electronic device (11), the connecting assembly (13) **characterized by**:
a plurality of first heat dissipating fins (13A) disposed on the first connecting component (131), an engaging portion (13A1) being formed on at least one of the plurality of first heat dissipating fins (13A);
a second connecting component (132) disposed on the second electronic device (12);
a plurality of second heat dissipating fins (13B) disposed on the second connecting component (132), a cooperating engaging portion (13B1) being formed on at least one of the plurality of second heat dissipating fins (13B); and
a pin (133) protruding from the first connecting component (131) and configured to be inserted into the second connecting component (132) along a first direction (D1), when the pin (133) is inserted into the second connecting component (132) along the first direction (D1), the plurality of first heat dissipating fins (13A) being configured to respectively be aligned with and abut against the plurality of second heat dissipating fins (13B) along the first direction (D1), and the engaging portion (13A1) being configured to engage with the cooperating engaging portion (13B1) along the first direction (D1) and abut against the cooperating engaging portion (13B1) along a second direction (D2) and a third direction (D3) opposite to each other and perpendicular to the first direction (D1).

2. The connecting assembly (13) of claim 1, **characterized in that** one and another one of the engaging portion (13A1) and the cooperating engaging portion (13B1) are an engaging protrusion and an engaging recess.

3. The connecting assembly (13) of claim 2, **characterized in that** a width of the engaging protrusion gradually decreases from a bottom of the engaging protrusion, and a width of the engaging recess gradually increases from a bottom of the engaging recess.

4. The connecting assembly (13) of any of claims 1 to 3, **characterized in that** a first engaging portion (13A11), a second engaging portion (13A12) and a third engaging portion (13A13) are respectively formed on a first one, a second one and a third one of the plurality of first heat dissipating fins (13A), the second one of the plurality of first heat dissipating fins (13A) is located between the first one and the third one of the plurality of first heat dissipating fins (13A) along an arranging direction of the plurality of first heat dissipating fins (13A), the second engaging portion (13A12) and the first engaging portion (13A11) are misaligned from each other along the arranging direction of the plurality of first heat dissipating fins (13A), the second engaging portion (13A12) and the third engaging portion (13A13) are misaligned from each other along the arranging direction of the plurality of first heat dissipating fins (13A), a first cooperating engaging portion (13B11), a second cooperating engaging portion (13B12) and a third cooperating engaging portion (13B13) are respectively formed on a first one, a second one and a third one of the plurality of second heat dissipating fins (13B), the second one of the plurality of second heat dissipating fins (13B) is located between the first one and the third one of the plurality of second heat dissipating fins (13B) along an arranging direction of the plurality of second heat dissipating fins (13B), the second cooperating engaging portion (13B12) and the first cooperating engaging portion (13B11) are misaligned from each other along the arranging direction of the plurality of second heat dissipating fins (13B), and the second cooperating engaging portion (13B12) and the third cooperating engaging portion (13B13) are misaligned from each other along the arranging direction of the plurality of second heat dissipating fins (13B).

5. The connecting assembly (13) of any of claims 1 to **4,** further **characterized by**:
a resilient component (134) disposed inside the second connecting component (132) and configured to apply a radial resilient force onto the pin (133) inserted into the second connecting component (132); and
a locking component (135) screwed onto the second connecting component (132) and configured to apply a radial locking force onto the pin (133) inserted into the second connecting component (132).

6. The connecting assembly (13) of claim 5, further **characterized by** an abutting component (136) disposed inside the second connecting component (132) and configured to abut against the pin (133), and the resilient component (134) abutting against the abutting component (136) to indirectly apply the radial resilient force onto the pin (133) via the abutting component (136).

7. The connecting assembly (13) of claim 6, **characterized in that** a groove (1331) is formed on an outer periphery of the pin (133) along a circumferential direction of the pin (133) and configured to cooperate with the abutting component (136) and the locking component (135).

8. The connecting assembly (13) of claim 7, further **characterized by** a sealing component (137) disposed between the first connecting component (131) and the second connecting component (132), and when the locking component (135) is screwed onto the second connecting component (132), a cooperation of the locking component (135) and the groove (1331) driving the pin (133) to move from an initial inserting position to a predetermined inserting position along the first direction (D1) for driving the first connecting component (131) to move along the first direction (D1) together with the pin (133), such that the sealing component (137) is clamped to be resiliently deformed by the first connecting component (131) and the second connecting component (132).

9. The connecting assembly (13) of any of claims 6 to 8, wherein the abutting component (136) is a ball-shaped structure or a protruding platform structure, the locking component (135) is a screw or a bolt, and the resilient component (134) is a compression spring.

10. The connecting assembly (13) of any of claims 1 to 4, further **characterized by** a sealing component (137) disposed between the first connecting component (131) and the second connecting component (132), a groove (1331) being formed on an outer periphery of the pin (133) along a circumferential direction of the pin (133) and configured to cooperate with locking component (135), and when the locking component (135) is screwed onto the second connecting component (132), a cooperation of the locking component (135) and the groove (1331) driving the pin (133) to move from an initial inserting position to a predetermined inserting position along the first direction (D1) for driving the first connecting component (131) to move along the first direction (D1) together with the pin (133), such that the sealing component (137) is clamped to be resiliently deformed by the first connecting component (131) and the second connecting component (132).

11. An electronic apparatus (1) comprising:
a first electronic device (11);
a second electronic device (12) detachably connected to the first electronic device (11); and
**characterized by**:
the connecting assembly (13) of any of claims 1 to 10, the connecting assembly (13) being configured to provide a aligning connection between the first electronic device (11) and the second electronic device (12).

## Patentansprüche

1. Verbindungsanordnung (13) zum Herstellen einer ausgerichteten Verbindung zwischen einem ersten elektronischen Gerät (11) und einem zweiten elektronischen Gerät (12), mit
einer ersten Verbindungskomponente (131), die an dem ersten elektronischen Gerät (11) angeordnet ist, worin die Verbindungsanordnung (13) **gekennzeichnet ist durch**:
mehrere erste Wärmeableitungsrippen (13A), die an der ersten Verbindungskomponente (131) angeordnet sind, worin ein Eingriffsabschnitt (13A1) an mindestens einer der mehreren ersten Wärmeableitungsrippen (13A) ausgebildet ist;
eine zweite Verbindungskomponente (132), die an dem zweiten elektronischen Gerät (12) angeordnet ist;
mehrere zweite Wärmeableitungsrippen (13B), die an der zweiten Verbindungskomponente (132) angeordnet sind, worin ein zusammenwirkender Eingriffsabschnitt (13B1) an mindestens einer der mehreren zweiten Wärmeableitungsrippen (13B) ausgebildet ist; und
ein Stift (133), der aus der ersten Verbindungskomponente (131) herausragt und ausgestaltet ist, entlang einer ersten Richtung (D1) in die zweite Verbindungskomponente (132) eingeführt zu werden, worin, wenn der Stift (133) entlang der ersten Richtung (D1) in die zweite Verbindungskomponente (132) eingeführt wird, die mehreren ersten Wärmeableitungsrippen (13A) ausgestaltet sind, dass sie entlang der ersten Richtung (D1) mit den mehreren zweiten Wärmeableitungsrippen (13B) entsprechend ausgerichtet sind und an diesen anliegen, und der Eingriffsabschnitt (13A1) ausgestaltet ist, entlang der ersten Richtung (D1) mit dem zusammenwirkenden Eingriffsabschnitt (13B1) in Eingriff zu kommen und entlang einer zweiten Richtung (D2) und einer dritten Richtung (D3), die einander entgegengesetzt und senkrecht zur ersten Richtung (D1) sind, an dem zusammenwirkenden Eingriffsabschnitt (13B1) anzuliegen.

2. Verbindungsanordnung (13) nach Anspruch 1, **dadurch gekennzeichnet, dass** einer von dem Eingriffsabschnitt (13A1) und dem zusammenwirkenden Eingriffsabschnitt (13B1) ein Eingriffsvorsprung und eine Eingriffsausnehmung sind.

3. Verbindungsanordnung (13) nach Anspruch 2, **dadurch gekennzeichnet, dass** die Breite des Eingriffsvorsprungs von der Unterseite des Eingriffsvorsprungs aus allmählich abnimmt und die Breite der Eingriffsausnehmung von der Unterseite der Eingriffsausnehmung aus allmählich zunimmt.

4. Verbindungsanordnung (13) nach einem der Ansprüche 1 bis 3, **dadurch gekennzeichnet, dass** ein erster Eingriffsabschnitt (13A11), ein zweiter Eingriffsabschnitt (13A12) und ein dritter Eingriffsabschnitt (13A13) entsprechend an einer ersten, einer zweiten und einer dritten der mehreren ersten Wärmeableitungsrippen (13A) ausgebildet sind, die zweite der mehreren ersten Wärmeableitungsrippen (13A) sich zwischen der ersten und der dritten der mehreren ersten Wärmeableitungsrippen (13A) entlang einer Anordnungsrichtung der mehreren ersten Wärmeableitungsrippen (13A) befindet, der zweite Eingriffsabschnitt (13A12) und der erste Eingriffsabschnitt (13A11) entlang der Anordnungsrichtung der mehreren ersten Wärmeableitungsrippen (13A) zueinander versetzt sind, der zweite Eingriffsabschnitt (13A12) und der dritte Eingriffsabschnitt (13A13) entlang der Anordnungsrichtung der mehreren ersten Wärmeableitungsrippen (13A) zueinander versetzt sind, ein erster zusammenwirkender Eingriffsabschnitt (13B11), ein zweiter zusammenwirkender Eingriffsabschnitt (13B12) und ein dritter zusammenwirkender Eingriffsabschnitt (13B13) an einem ersten, einem zweiten und einem dritten der mehreren zweiten Wärmeableitungsrippen (13B) entsprechend ausgebildet sind, worin sich die zweite der mehreren zweiten Wärmeableitungsrippen (13B) zwischen der ersten und der dritten der mehreren zweiten Wärmeableitungsrippen (13B) entlang einer Anordnungsrichtung der mehreren zweiten Wärmeableitungsrippen (13B) befindet, worin der zweite zusammenwirkende Eingriffsabschnitt (13B12) und der erste zusammenwirkende Eingriffsabschnitt (13B11) entlang der Anordnungsrichtung der mehreren zweiten Wärmeableitungsrippen (13B) zueinander versetzt sind, und der zweite zusammenwirkende Eingriffsabschnitt (13B12) und der dritte zusammenwirkende Eingriffsabschnitt (13B13) entlang der Anordnungsrichtung der mehreren zweiten Wärmeableitungsrippen (13B) zueinander versetzt sind.

5. Verbindungsanordnung (13) nach einem der Ansprüche 1 bis 4, ferner **gekennzeichnet durch**:
eine elastische Komponente (134), die innerhalb der zweiten Verbindungskomponente (132) angeordnet und ausgestaltet ist, eine radiale elastische Kraft auf den in die zweite Verbindungskomponente (132) eingeführten Stift (133) auszuüben; und
eine Verriegelungskomponente (135), die auf die zweite Verbindungskomponente (132) geschraubt und ausgestaltet ist, eine radiale Verriegelungskraft auf den in die zweite Verbindungskomponente (132) eingeführten Stift (133) auszuüben.

6. Verbindungsanordnung (13) nach Anspruch 5, ferner **gekennzeichnet durch** eine Anschlagkomponente (136), die innerhalb der zweiten Verbindungskomponente (132) angeordnet und ausgestaltet ist, gegen den Stift (133) anzuschlagen, und darin, dass die elastische Komponente (134) gegen die Anschlagkomponente (136) anschlägt, um die radiale elastische Kraft über die Anschlagkomponente (136) indirekt auf den Stift (133) auszuüben.

7. Verbindungsanordnung (13) nach Anspruch 6, **dadurch gekennzeichnet, dass** eine Nut (1331) an einem Außenumfang des Stifts (133) entlang einer Umfangsrichtung des Stifts (133) ausgebildet und ausgestaltet ist, mit der Anschlagkomponente (136) und der Verriegelungskomponente (135) zusammenzuwirken.

8. Verbindungsanordnung (13) nach Anspruch 7, ferner **gekennzeichnet durch** eine Dichtungskomponente (137), die zwischen der ersten Verbindungskomponente (131) und der zweiten Verbindungskomponente (132) angeordnet ist, und darin, dass, wenn die Verriegelungskomponente (135) auf die zweite Verbindungskomponente (132) geschraubt wird, ein Zusammenwirken der Verriegelungskomponente (135) und der Nut (1331) den Stift (133) dazu veranlasst, sich von einer anfänglichen Einführposition entlang der ersten Richtung (D1) zu einer vorbestimmten Einführposition zu bewegen, so dass die Dichtungskomponente (137) durch die erste Verbindungskomponente (131) und die zweite Verbindungskomponente (132) geklemmt wird, um elastisch verformt zu werden.

9. Verbindungsanordnung (13) nach einem der Ansprüche 6 bis 8, worin die Anschlagkomponente (136) eine kugelförmige Struktur oder eine vorstehende Plattformstruktur ist, die Verriegelungskomponente (135) eine Schraube oder ein Bolzen ist und die elastische Komponente (134) eine Druckfeder ist.

10. Verbindungsanordnung (13) nach einem der Ansprüche 1 bis 4, ferner **gekennzeichnet durch** eine Dichtungskomponente (137), die zwischen der ersten Verbindungskomponente (131) und der zweiten Verbindungskomponente (132) angeordnet ist, worin eine Nut (1331) an einem Außenumfang des Stifts (133) entlang einer Umfangsrichtung des Stifts (133) ausgebildet und ausgestaltet ist, mit der Verriegelungskomponente (135) zusammenzuwirken, und wenn die Verriegelungskomponente (135) auf die zweite Verbindungskomponente (132) geschraubt wird, ein Zusammenwirken der Verriegelungskomponente (135) und der Nut (1331) den Stift (133) dazu antreibt, sich von einer anfänglichen Einführposition entlang der ersten Richtung (D1) in eine vorbestimmte Einführposition zu bewegen, um die erste Verbindungskomponente (131) dazu anzutreiben, sich zusammen mit dem Stift (133) entlang der ersten Richtung (D1) zu bewegen, so dass die Dichtungskomponente (137) geklemmt wird, um durch die erste Verbindungskomponente (131) und die zweite Verbindungskomponente (132) elastisch verformt zu werden.

11. Elektronische Vorrichtung (1), welche umfasst:
ein erstes elektronisches Gerät (11);
ein zweites elektronisches Gerät (12), das lösbar mit dem ersten elektronischen Gerät (11) verbunden ist; und
**gekennzeichnet durch**:
die Verbindungsanordnung (13) nach einem der Ansprüche 1 bis 10, worin die Verbindungsanordnung (13) ausgestaltet ist, eine ausgerichtete Verbindung zwischen dem ersten elektronischen Gerät (11) und dem zweiten elektronischen Gerät (12) bereitzustellen.

## Revendications

1. Ensemble de connexion (13) destiné à fournir une connexion d'alignement entre un premier dispositif électronique (11) et un deuxième dispositif électronique (12), comprenant un premier composant de connexion (131) disposé sur le premier dispositif électronique (11), l'ensemble de connexion (13) étant **caractérisé par**:
une pluralité de premières ailettes de dissipation thermique (13A) disposées sur le premier composant de connexion (131), une partie d'engagement (13A1) étant formée sur au moins une de la pluralité de premières ailettes de dissipation thermique (13A);
un deuxième composant de connexion (132) disposé sur le deuxième dispositif électronique (12);
une pluralité de deuxièmes ailettes de dissipation thermique (13B) disposées sur le deuxième composant de connexion (132), une partie d'engagement coopérante (13B1) étant formée sur au moins une de la pluralité de deuxièmes ailettes de dissipation thermique (13B); et
une broche (133) dépassant du premier composant de connexion (131) et configurée pour être insérée dans le deuxième composant de connexion (132) le long d'une première direction (D1), lorsque la broche (133) est insérée dans le deuxième composant de connexion (132) le long de la première direction (D1), la pluralité de premières ailettes de dissipation thermique (13A) étant configurées pour être respectivement alignées avec et buter contre la pluralité de deuxièmes ailettes de dissipation thermique (13B) le long de la première direction (D1), et la partie d'engagement (13A1) étant configurée pour s'engager avec la partie d'engagement coopérante (13B1) le long de la première direction (D1) et buter contre la partie d'engagement coopérante (13B1) le long d'une deuxième direction (D2) et d'une troisième direction (D3) opposées l'une à l'autre et perpendiculaires à la première direction (D1).

2. Ensemble de connexion (13) selon la revendication 1, **caractérisé en ce que** l'une et l'autre de la partie d'engagement (13A1) et de la partie d'engagement coopérante (13B1) sont une saillie d'engagement et un évidement d'engagement.

3. Ensemble de connexion (13) selon la revendication 2, **caractérisé en ce que** la largeur de la saillie d'engagement diminue progressivement à partir du fond de la saillie d'engagement, et la largeur de l'évidement d'engagement augmente progressivement à partir du fond de l'évidement d'engagement.

4. Ensemble de connexion (13) de l'une quelconque des revendications 1 à 3, **caractérisé en ce qu'**une première partie d'engagement (13A11), une deuxième partie d'engagement (13A12) et une troisième partie d'engagement (13A13) sont respectivement formées sur une première, une deuxième et une troisième de la pluralité de premières ailettes de dissipation thermique (13A), la deuxième de la pluralité de premières ailettes de dissipation thermique (13A) étant située entre la première et la troisième de la pluralité de premières ailettes de dissipation thermique (13A) le long d'une direction d'agencement de la pluralité de premières ailettes de dissipation thermique (13A), la deuxième partie d'engagement (13A12) et la première partie d'engagement (13A11) sont désalignées l'une par rapport à l'autre le long de la direction d'agencement de la pluralité de premières ailettes de dissipation thermique (13A), la deuxième partie d'engagement (13A12) et la troisième partie d'engagement (13A13) sont désalignées l'une par rapport à l'autre le long de la direction d'agencement de la pluralité de premières ailettes de dissipation thermique (13A), une première partie d'engagement coopérante (13B11), une deuxième partie d'engagement coopérante (13B12) et une troisième partie d'engagement coopérante (13B13) sont respectivement formées sur une première, une deuxième et une troisième de la pluralité de deuxièmes ailettes de dissipation thermique (13B), la deuxième de la pluralité de deuxièmes ailettes de dissipation thermique (13B) est située entre la première et la troisième de la pluralité de deuxièmes ailettes de dissipation thermique (13B) le long d'une direction d'agencement de la pluralité de deuxièmes ailettes de dissipation thermique (13B), la deuxième partie d'engagement coopérante (13B12) et la première partie d'engagement coopérante (13B11) sont désalignées l'une par rapport à l'autre le long de la direction d'agencement de la pluralité de deuxièmes ailettes de dissipation thermique (13B), et la deuxième partie d'engagement coopérante (13B12) et la troisième partie d'engagement coopérante (13B13) sont désalignées l'une par rapport à l'autre le long de la direction d'agencement de la pluralité de deuxièmes ailettes de dissipation thermique (13B).

5. Ensemble de connexion (13) de l'une quelconque des revendications 1 à 4, **caractérisé en outre par**:
un composant élastique (134) disposé à l'intérieur du deuxième composant de connexion (132) et configuré pour appliquer une force élastique radiale sur la broche (133) insérée dans le deuxième composant de connexion (132); et
un composant de verrouillage (135) vissé sur le deuxième composant de connexion (132) et configuré pour appliquer une force de verrouillage radiale sur la broche (133) insérée dans le deuxième composant de connexion (132).

6. Ensemble de connexion (13) selon la revendication 5, **caractérisé en outre par** un composant de butée (136) disposé à l'intérieur du deuxième composant de connexion (132) et configuré pour venir en butée contre la broche (133), et le composant élastique (134) venant en butée contre le composant de butée (136) pour appliquer indirectement la force élastique radiale sur la broche (133) via le composant de butée (136).

7. Ensemble de connexion (13) selon la revendication 6, **caractérisé en ce qu'**une rainure (1331) est formée sur une périphérie extérieure de la broche (133) le long d'une direction circonférentielle de la broche (133) et configurée pour coopérer avec le composant de butée (136) et le composant de verrouillage (135).

8. Ensemble de connexion (13) selon la revendication 7, **caractérisé en outre par** un composant d'étanchéité (137) disposé entre le premier composant de connexion (131) et le deuxième composant de connexion (132), et lorsque le composant de verrouillage (135) est vissé sur le deuxième composant de connexion (132), une coopération entre le composant de verrouillage (135) et la rainure (1331) entraînant la broche (133) à se déplacer d'une position d'insertion initiale à une position d'insertion prédéterminée le long de la première direction (D1) pour entraîner le premier composant de connexion (131) à se déplacer le long de la première direction (D1) avec la broche (133), de telle sorte que le composant d'étanchéité (137) soit serré pour être déformé de manière élastique par le premier composant de connexion (131) et le deuxième composant de connexion (132).

9. Ensemble de connexion (13) de l'une quelconque des revendications 6 à 8, dans lequel le composant de butée (136) est une structure en forme de bille ou une structure de plate-forme en saillie, le composant de verrouillage (135) est une vis ou un boulon, et le composant élastique (134) est un ressort de compression.

10. Ensemble de connexion (13) de l'une quelconque des revendications 1 à 4, **caractérisé en outre par** un composant d'étanchéité (137) disposé entre le premier composant de connexion (131) et le deuxième composant de connexion (132), une rainure (1331) étant formée sur une périphérie extérieure de la broche (133) le long d'une direction circonférentielle de la broche (133) et configurée pour coopérer avec le composant de verrouillage (135), et lorsque le composant de verrouillage (135) est vissé sur le deuxième composant de connexion (132), une coopération du composant de verrouillage (135) et de la rainure (1331) entraînant la broche (133) à se déplacer d'une position d'insertion initiale à une position d'insertion prédéterminée le long de la première direction (D1) pour entraîner le premier composant de connexion (131) à se déplacer le long de la première direction (D1) avec la broche (133), de telle sorte que le composant d'étanchéité (137) soit serré pour être déformé de manière élastique par le premier composant de connexion (131) et le deuxième composant de connexion (132).

11. Appareil électronique (1) comprenant:
un premier dispositif électronique (11);
un deuxième dispositif électronique (12) connecté de manière amovible au premier dispositif électronique (11); et
**caractérisé par**:
l'ensemble de connexion (13) de l'une quelconque des revendications 1 à 10, l'ensemble de connexion (13) étant configuré pour fournir une connexion d'alignement entre le premier dispositif électronique (11) et le deuxième dispositif électronique (12).
